# EUROPEAN PATENT SPECIFICATION

(11) **EP 1 607 939 B1**
(45) Date of publication and mention of the grant of the patent: **04.03.2009**
(21) Application number: 04723806.8
(22) Date of filing: 26.03.2004
(51) Int. Cl.: G10L 21/02, H03G 3/34

(54) **SPEECH SIGNAL COMPRESSION DEVICE, SPEECH SIGNAL COMPRESSION METHOD, AND PROGRAM**
SPRACHSIGNALKOMPRIMIERUNGSEINRICHTUNG, SPRACHSIGNALKOMPRIMIERUNGSVERFAHREN UND PROGRAMM
DISPOSITIF DE COMPRESSION DE SIGNAL DE PAROLE, PROCEDE DE COMPRESSION DE SIGNAL DE PAROLE, ET PROGRAMME

(30) Priority: 26.03.2003 JP 2003084479
(43) Date of publication of application: 21.12.2005
(73) Proprietor: Kabushiki Kaisha Kenwood, Hachioji-shi, Tokyo 192-8525 (JP); National Institute of Advanced Industrial Science and Technology, Tokyo 100-0013 (JP)
(72) Inventor: SATO, Yasushi Rouyarukoupo Watanabe 401, Nagareyama-shi Chiba 2700163 (JP); KOJIMA, Hiroaki Nat. Inst. Adv. Ind. Sci. & Techn., Tsukuba-shi Ibaraki 3058568 (JP); TANAKA, Kazuyo Nat. Inst. Adv. Ind. Sci & Techn., Tsukuba-shi Ibaraki 3058568 (JP)
(74) Representative: Leinweber & Zimmermann
(86) International application number: PCT/JP2004/004306
(87) International publication number: WO 2004/086362

(56) References cited:
- EP-A- 0 438 174
- JP-A- 3 212 698
- JP-A- 6 348 293
- JP-A- 7 193 548
- JP-A- 9 044 186
- JP-A- 11 175 083
- JP-A- 60 086 429
- JP-A- 2003 015 700
- US-A- 4 627 102
- US-B1- 6 360 203

## Description

### Technical Field

The present invention relates to a speech signal noise elimination device, speech signal noise elimination method, and program.

### Background Art

As a technique of eliminating a noise by a device which processes speech signals, such as a radio receiver, a squelch circuit is known (refer to Japanese Patent No. 2543542, for example).

Squelch circuit is a circuit in which it is determined whether or not the level of a signal to be reproduced (a detected signal obtained by detecting a modulated wave, for example) reaches a predetermined value, and if so, this signal is sent to the rear stage, and if not, this signal is cut off. Because of the operation by the squelch circuit, in a state where the signal level is lower than a certain value, a signal of poor quality having a small signal-to-noise ratio is prevented from being reproduced.

Alternatively, squelch systems may detect speech signal portions by using the zero-crossing rate of a signal as disclosed in the US patent 4,627,102 ("Squelch Circuit", 01.12.1986, Inventor: Henry A. Nott).

### Disclosure of the Invention

However, when a large amount of noise is mixed in a detected signal etc, a squelch circuit cannot distinguish the signal level from the noise level, thus failing to operate normally.

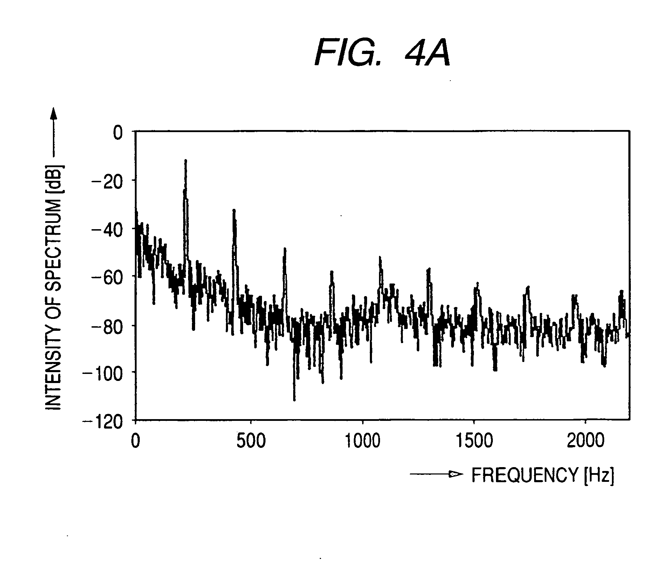

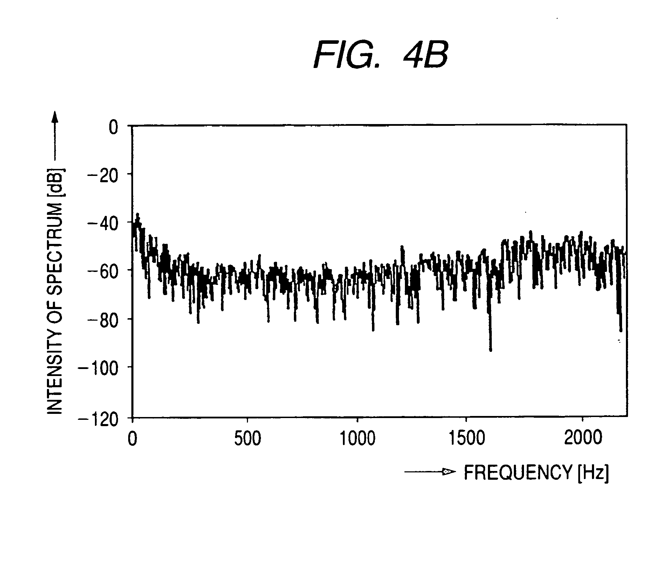

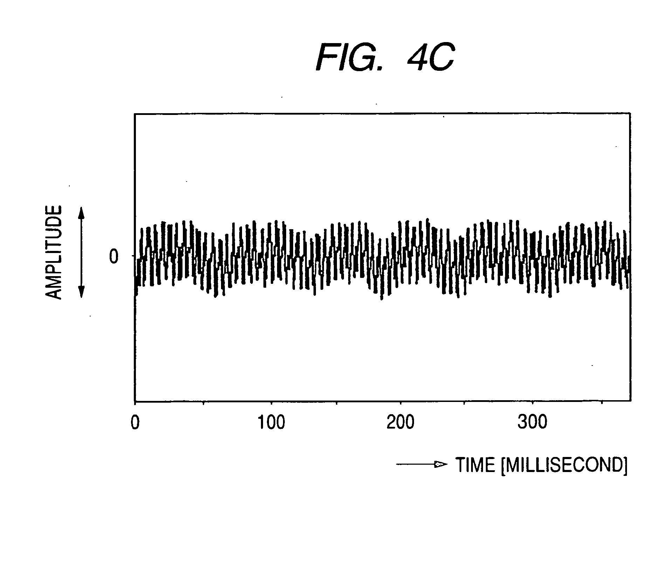

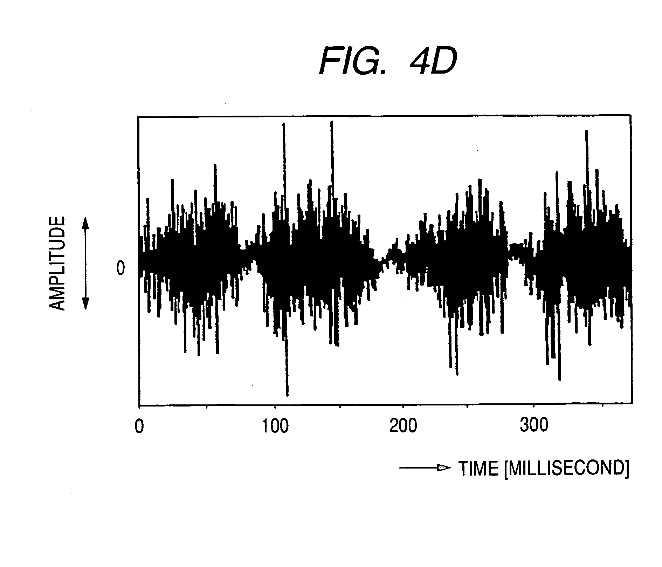

Meanwhile, a vehicle etc. generally generates a large noise relative to a human speech, for example, as shown in Figure 4. Consequently, in a speech generated by a person from the inside of the vehicle, a noise larger than this speech will be generally mixed. (Figure 4(a) is a graph showing an exemplary spectrum of a human speech; Figure 4(b) is a graph showing an exemplary spectrum of a noise generated by a vehicle etc.; Figure 4(c) is a graph showing an exemplary waveform of a human voice; Figure 4(d) is a graph showing an exemplary waveform of a noise generated by a vehicle etc.)

Accordingly, even if the conventional squelch circuit is used in, for example, a vehicle-in apparatus such as a car navigation which responds to a speech, there will be a high risk of malfunction.

The present invention addresses the above problem, with the object of providing a speech signal noise elimination device, speech signal noise elimination method, and program for surely eliminating a noise mixed in a speech.

To achieve the above object, a speech signal noise elimination device, method and computer program as defined by the set of claims is disclosed.

### Brief Description of the Drawings

Figure 1 is a block diagram showing a configuration of a speech data noise eliminator according to an embodiment of the present invention;
Figure 2 is a block diagram showing a configuration of a modification of the speech data noise eliminator of Figure 1;
Figure 3 is a flowchart showing an operation of the modification of the speech data noise eliminator of Figure 1;
Figure 4(A) is a graph showing an exemplary spectrum of a human speech;
Figure 4(B) is a graph showing an exemplary spectrum of a noise generated by a vehicle etc.;
Figure 4(C) is a graph showing an exemplary waveform of a human voice; and
Figure 4(D) is a graph showing an exemplary waveform of a noise generated by a vehicle etc.

### Best Mode for Carrying Out the Invention

An embodiment of the present invention will be described below with reference to the drawings.

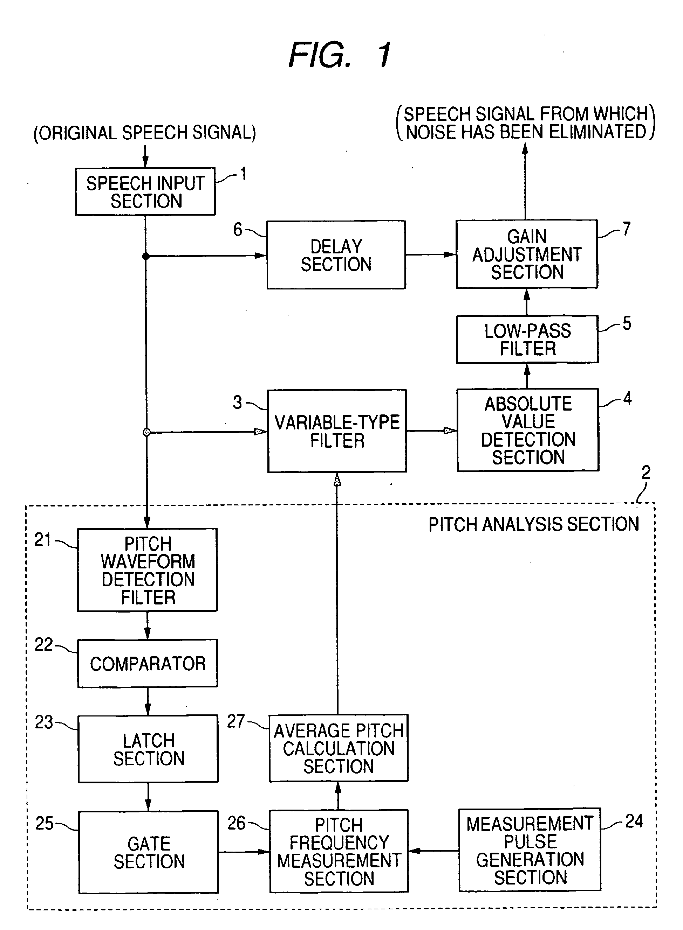

Figure 1 is a block diagram showing a configuration of a speech data noise eliminator according to an embodiment of the present invention. As shown in the drawing, the speech data noise eliminator includes a speech input section 1, pitch analysis section 2, variable type filter 3, absolute value detection section 4, low-pass filter 5, delay section 6, and gain adjustment section 7.

The speech input section 1 is constituted of a microphone, AF (Audio Frequency) amplifier, and so on, for example. The speech input section 1 collects a speech generated by a speaker, and creates and amplifies a speech signal representing the waveform of the speech, and supplies the amplified signal simultaneously to the variable type filter 3, delay section 6, and a pitch waveform detection filter 21 described later of the pitch analysis section 2.

As shown in Figure 1, the pitch analysis section 2 includes the pitch waveform detection filter 21, a comparator 22, latch section 23, measurement pulse generator 24, gate section 25, pitch frequency measurement section 26, and average pitch calculator 27.

The pitch waveform detection filter 21 is constituted of a band-pass filter etc. The pitch waveform detection filter 21 passes from among the original speech signal supplied by the speech input section 1, components of a band in which the pitch component (the component having the fundamental frequency) of a human speech can be ordinarily contained, and supplies the components to the comparator 22. (Specifically, the band ranges from about 100 Hz to about 400 Hz.) Meanwhile, components not contained in this band are substantially cut off. (The components which pass through the pitch waveform detection filter 21 are hereinafter referred to the lower components.)

The lower components are identical to those obtained by eliminating from the speech signal, components of a band in which the pitch component of a human speech is not ordinarily contained, so the waveform of the lower components is close to a sinusoidal wave compared to the original speech signal.

The comparator 22 is constituted of, for example, a comparator and reference voltage source etc. supplying a predetermined reference voltage to any one of multiple input terminals of this comparator.

The comparator 22 determines whether or not the intensity of the lower components supplied by the pitch waveform detection filter 21 exceeds a predetermined reference level and generates a signal representing the determination result (hereinafter referred to as the level detection signal) and supplies the signal to the latch section 23.

Specifically, for example, the level detection signal may be a pulse signal to hold a predetermined high level representing logical value "1" during a time period when the intensity of the lower components exceeds the reference level, and hold a predetermined low level representing logical value "0" during a time period when the intensity of the lower components is the reference level or less. Alternatively, the level detection signal may be a pulse signal to hold a low level during a time period when the intensity of the lower components exceeds the reference level, and hold a high level during a time period when the intensity of the lower components is the reference level or less.

The latch section 23 is constituted of a flip-flop circuit etc., for example. Based on the level detection signal supplied from the comparator 22, the latch section 23 generates a signal indicating the length corresponding to one pitch of the speech signal (hereinafter referred to as the pitch detection signal) and supplies the signal to the gate section 25.

In the case where the level detection signal is, as described above, composed of a pulse signal that holds a high level (or a low level) during a time period when the intensity of the lower components exceeds the reference level, and holds a low level (or a high level) during a time period when the intensity of the lower components is the reference level or less, then the pitch detection signal is, for example, a signal that repeats alternately (i.e., toggles) a shift from a high level to a low level and a shift from a low level to a high level each time the level detection signal rises. Alternatively, the pitch detection signal may be a signal that toggles each time the level detection signal descends.

The level detection signal generated from a vowel etc. containing a sufficiently large amount of the pitch component is generated by use of the lower components having a waveform close to a sinusoidal wave. Accordingly, when the comparator 22 generates the above described pulse signal as the level detection signal, in the above described pitch detection signal which toggles in response to any one of the rise or descending of the pulse signal, it can be presumed that the time length from the rise to the descending and the time length from the descending to the rise each corresponds to one period of the pitch component contained in the original speech signal.

Meanwhile, the level detection signal generated from the lower components obtained from an interval of the original speech signal not containing many pitch components (a soundless interval or an interval corresponding to consonants of plosive sounds or friction sounds, etc., for example), indicates that the intensity of the lower components does not reach the reference level throughout the entire part representing this sound. When the comparator 22 generates the above described pulse signal as the level detection signal, this pulse signal holds the low level throughout the entire part representing this sound. Consequently, the above described pitch detection signal, which toggles in response to any one of the rise or descending of this pulse signal, holds the high level or low level throughout this same part.

The measurement pulse generator 24 constituted of a quartz crystal oscillator etc. generates a measurement pulse signal having a certain frequency sufficiently higher than the fundamental frequency of human voice, and supplies the signal continuously to the gate section 25.

When the pitch detection signal is supplied from the latch section 23 and the measurement pulse signal is supplied from the measurement pulse generator 24, then the gate section 25, which is constituted of, for example, an AND circuit etc., passes the supplied measurement pulse signal to the pitch frequency measurement section 26 during a time period from when the pitch detection signal indicates the start point of one period of the pitch component to when the pitch detection signal indicates the terminal point thereof, and cuts off the measurement pulse signal during the other time period.

Specifically, for example, in the case where the pitch detection signal toggles in response to any one of the rise or descending of a pulse signal, and this pulse signal holds a high level (or low level) during a time period when the intensity of the lower components exceeds the reference level, and holds a low level (or high level) during a time period when the intensity of the lower components is the reference level or less, then the gate section 25 may passes the supplied measurement pulse signal to the pitch frequency measurement section 26 during a time period from when the pitch detection signal rises to when the pitch detection signal descends, and cut off the measurement pulse signal during the other time period. Alternatively, the gate section 25 may pass the supplied measurement pulse signal during a time period from when the pitch detection signal descends to when the pitch detection signal rises, and may cut off the measurement pulse signal during the other time period.

The pitch frequency measurement section 26 is constituted of a resettable counter circuit etc., for example. The pitch frequency measurement section 26 counts the number of pulses contained in the measurement pulse signal which has passed through the gate section 25 during a time period from when the gate section 25 initiates the passing of the measurement pulse signal to when the gate section 25 initiates the cutting off of the measurement pulse signal, and determines a measured value of the pitch component frequency of the original speech signal based on the measurement result, and notifies the measured value thus determined to the average pitch calculator 27.

Specifically, for example, in the case where it can be presumed that the time length from when the pitch detection signal rises to when it descends (or the time length from when the pitch detection signal descends to when it rises) corresponds to one period of the pitch component contained in the original speech signal, when the gate section 25 passes the supplied measurement pulse signal to the pitch frequency measurement section 26 during a time period when the pitch detection signal holds a high level (or low level), the pitch frequency measurement section 26, defining as the measured value of the pitch component frequency of the original speech signal, a value obtained by multiplying the frequency of the measurement pulse signal by the inverse number of the number of pulses measured during the time period when the gate section 25 initiates the passing of the measurement pulse signal to when the gate section 25 initiates the cutting off of the measurement pulse signal, generates data indicating this measured value and supplies the data to the average pitch calculator 27.

As described above, in that part of the pitch detection signal which corresponds to an interval of the original speech signal not containing a large amount of the pitch component, the pitch detection signal holds a high level or low level throughout this said part. Accordingly, when the gate section 25 passes the supplied measurement pulse signal to the pitch frequency measurement section 26 during the time period from when the pitch detection signal rises to when it descends (or during the time period from when the pitch detection signal descends to when it rises), the measured value of frequency will have a sufficiently large value relative to the fundamental frequency of a speech of an ordinary person, or have a sufficiently small value relative to the fundamental frequency of a speech of an ordinary person.

Specifically, for example, in the case where the pitch detection signal holds a high level throughout this said part and the gate section 25 passes the measurement pulse signal during the time period when the pitch detection signal holds the high level, or in the case where the pitch detection signal holds a low level throughout this said part and the gate section 25 passes the measurement pulse signal during the time period when the pitch detection signal holds the low level, the measurement pulse signal supplied to the gate section 25 during the time period when this said part of the pitch detection signal is supplied to the gate section 25, entirely passes to the pitch frequency measurement section 26. Consequently, for example, the counter constituting the pitch frequency measurement section 26 will overflow, whereby the measured value of frequency has a very small value relative to the fundamental frequency of a speech of an ordinary person.

Meanwhile, for example, in the case where the pitch detection signal holds a low level throughout this said part and the gate section 25 passes the measurement pulse signal during the time period when the pitch detection signal holds the high level, or in the case where the pitch detection signal holds a high level throughout this said part and the gate section 25 passes the measurement pulse signal during the time period when the pitch detection signal holds the low level, the measurement pulse signal supplied to the gate section 25 during the time period when this said part of the pitch detection signal is supplied to the gate section 25 is substantially entirely cut off. Consequently, the measured value of frequency reaches substantially an infinite value.

The average pitch calculator 27 is constituted of, for example, a processor, such as a CPU (Central Processing Unit) or DSP (Digital Signal Processor), and a memory etc. such as an RAM (Random Access Memory) having a storage area which serves as a working area of the processor. Whenever the average pitch calculator 27 is notified of a new measured value of frequency by the pitch frequency measurement section 26, the calculator 27 calculates the arithmetic average (i.e., moving correction average) of a number n (n: a given positive integral number) of measured values of frequency from among the latest measured values notified until this time, and notifies this moving correction average value to the variable-type filter 3.

The technique by which the average pitch calculator 27 notifies the moving correction average value to the variable-type filter 3 is arbitrary; for example, a digital signal indicating the moving correction average value is generated and supplied to the variable-type filter 3, or alternatively a physical value (voltage, electronic current, or frequency, for example) indicating the moving correction average value is generated and supplied to the variable-type filter 3.

It is noted that, whenever the moving correction average is calculated, the average pitch calculator 27 determines whether or not the measured value of frequency notified by the pitch frequency measurement section 26 is distant by a certain amount or more from the range of value which can be assumed by the fundamental frequency of a speech of an ordinary person, and any measured value determined to be distant by a certain amount or more is eliminated from the objects to be used for calculating the moving correction average.

When, for example, a number k (k: an integral number of one or more and smaller than n) of measured values are eliminated from among a number n of the latest measured values, the arithmetic average of a number (n - k) of the remaining measured values is calculated, for example; or alternatively, the arithmetic average is calculated by use of a number k of the latest measured values from among the (n + 1)-th values determined anew and not eliminated, instead of a number k of the eliminated measured values.

Further, as an exceptional case, when all of a number n (or a predetermined number of one or more and smaller than n) of the latest measured values of frequency is eliminated from the objects to be used for calculating the moving correction average, the average pitch calculator 27 does not calculate the moving correction average, but instead notifies to the variable-type filter 3, a predetermined value (0, for example) indicating that no moving correction average has been calculated.

The variable-type filter 3, which acts as a band-pass filter whose center frequency is variable, is constituted of a processor, memory, etc., for example. Alternatively, the variable-type filter 3 may be constituted of passive elements (resistor, capacitor, coil, etc.) whose element constant is variable, operational amplifiers, etc.

The variable-type filter 3 sets the center frequency thereof to a value notified by the average pitch calculator 27, i.e., to a frequency corresponding to the moving correction average of a predetermined number of the latest measured values determined by the pitch frequency measurement section 26. Then the variable-type filter 3 filters the original speech signal supplied from the speech input section 1, generates a signal (hereinafter referred to as the pitch signal) representing the waveform of the filtered speech signal, and supplies this pitch signal to the absolute value detection section 4. When a value indicating that no moving correction average has been calculated is notified, then the variable-type filter 3 cuts off all the components of the original speech signal.

The pitch signal is a signal composed of components in the vicinity of the fundamental frequency of the original speech signal, so it can be presumed that the pitch signal represents the intensity of the pitch component.

It is desirable that the variable-type filter 3 performs the filtering of one interval of the original speech signal by adjusting a timing so that components other than the center frequency and vicinity thereof are substantially eliminated, the center frequency being obtained as the moving correction average determined by the average pitch calculator 27 which uses the value of frequency in this said interval as the latest measured value. In order to perform the filtering at such timing, the variable-type filter 3 may cause the original speech signal to be delayed, for example. In this case, to perform this delay operation, the variable-type filter 3 includes a delay circuit constituted of a delay line, integration circuit, shift register, or the like, for example.

Also, to prevent harmonic components from being mixed in the pitch signal, it is desirable that the pass bandwidth of the variable-type filter 3 is smaller than double the center frequency.

The absolute value detection section 4 is constituted of an absolute value circuit, logarithmic amplifier, etc. The absolute value detection section 4 generates a signal having a value corresponding to the absolute value of the pitch signal supplied from the variable-type filter 3, and supplies this signal to the low-pass filter 5.

The low-pass filter 5 supplies to the gain adjustment section 7, a signal (hereinafter referred to as the gain adjustment signal) obtained by filtering the signal supplied from the absolute value detection section 4. The pass band characteristic of the low-pass filter 5 is such that the signal-to-noise ratio of an output speech signal outputted by the gain adjustment section 7 can be higher than a desired value, for example. Thus, the pass band characteristic is experimentally determined by performing experiments.

The delay section 6 is constituted of a delay circuit etc. including a delay line, integration circuit, shift register, or the like, for example. The delay section 6 delays a speech signal supplied from the speech input section 1 and supplies the signal to the gain adjustment section 7.

The length of time by which the delay section 6 delays a speech signal is substantially equal to the sum of time lengths indicated as the following (1) and (2):
(1) A time period taken from when a speech signal is supplied simultaneously to the delay section 6 and variable-type filter 3 to when this speech signal is supplied to the gain adjustment section 7 as the gain adjustment signal via the variable-type filter 3, absolute value detection section 4 and low-pass filter 5; and
(2) A maximum time length taken up by a consonant immediately before a vowel.

The gain adjustment section 7 is constituted of a variable gain amplifier etc., for example. The gain adjustment section 7 amplifies the original speech signal supplied from the delay section 6 by use of a larger gain as the level of the gain adjustment signal supplied from the low-pass filter 5 is higher (or attenuates the original speech signal by use of a larger rate of attenuation as the level of the gain adjustment signal is lower), and outputs the resultant signal.

The delay section 6 delays the original speech signal by the time length corresponding to the sum of time lengths of (1) and (2); consequently, by use of the gain (or rate of attenuation) determined by the gain adjustment signal generated based on the moving correction average of the fundamental frequency of a part representing one vowel in the original speech signal, the vowel and a consonant immediately before the vowel are amplified (or attenuated) by the gain adjustment section 7. Specifically, the delay section 6 delays the original speech signal, whereby a gain determined based on the intensity of the fundamental frequency component of one part of the speech signal is applied as the gain of the gain adjustment section 7 from a time point which precedes a predetermined time period relative to the beginning of the one part.

As described above, consonants (particularly, plosive sounds and friction sounds) are characterized in that they don't contain a large amount of the pitch component. Meanwhile, of the original speech signal, parts not containing a large amount of the pitch component are amplified by use of a smallest gain (or attenuated) except for parts having a predetermined time length preceding parts containing a large amount of the pitch component. Consequently, of the original speech signal, parts preceding a vowel etc. and representing a consonant are not eliminated; meanwhile, the other parts not containing a large amount of the pitch component are relatively significantly attenuated.

The gain characteristic of the gain adjustment section 7 with respect to the level of the gain adjustment signal is such that the gain of the gain adjustment section 7 is substantially a linear function of the level of the gain adjustment signal, for example. The value of coefficient (coefficient of first degree) and intercept (coefficient of zero degree) of this linear function are determined by performing experiments etc. so that the speech signal outputted by the gain adjustment section 7 meets the desired standards (such that the signal-to-noise ratio becomes a predetermined value or more, for example).

By performing the above described operation, the speech data noise eliminator detects the intensity of the pitch component of speech represented by the original speech signal, and attenuates the original speech signal by use of a predetermined response such that the rate of amplification becomes larger as the intensity of the detected pitch component is larger (or the rate of attenuation is larger as the intensity of the pitch component is smaller).

Accordingly, the rate of amplification (or rate of attenuation) which efficiently raises the signal-to-noise ratio while suppressing the deterioration of speech to within a desired range, can be set according to the speech intensity. If a speech signal whose pitch component has a certain intensity is acquired by the speech input section 1, even when the speech signal contains various levels of noises, this speech signal can be surely amplified (or attenuated) by use of the rate of amplification (or rate of attenuation) set corresponding to this same intensity of the pitch component.

The configuration of the speech data noise eliminator is not limited to the above described one.

For example, part of or all of the functions of the pitch analysis section 2, variable-type filter 3, absolute value detection section 4, low-pass filter 5, delay section 6 and gin adjustment section 7 may be performed by a single or multiple processors and memories.

Also, a single processor may perform part of or all of the functions of the pitch waveform detection filter 21, comparator 22, latch section 23, measurement pulse generator 24, gate section 25, pitch frequency measurement section 26, and average pitch calculator 27.

Also, the pitch analysis section 2 does not always have to determine the moving correction average with respect to the measured values of frequency of the pitch component, but may supply the measured value measured by the pitch frequency measurement section 26 directly to the variable-type filter 3.

Also, the absolute value detection section 4 may supply the signal generated thereby not via the low-pass filter 5 but directly to the gain adjustment section 7 as a gain adjustment signal.

Also, the speech signal handled by the speech data noise eliminator, and the gain adjustment signal, and the signals generated in the process of generating the gain adjustment signal may be composed of a digital format signal. In this case, the speech input section 1 includes an A/D (Analog-to-Digital) converter etc. for converting the form of a speech signal collected by a microphone etc. to digital form and supplying the signal to the pitch analysis section 2, variable-type filter 3 and delay section 6. Alternatively, a speech signal which has been preliminarily converted to digital form may be supplied to the speech input section 1; the speech input section 1 acquires this speech signal. The gain adjustment section 7 may include, for example, a D/A (Digital-to-Analog) converter etc. for converting a speech signal from digital form to analog form and outputting the signal.

Also, in a case where the features of speech of a speaker are preliminarily identified, the pitch waveform detection filter 21 may pass the component of a band of the original speech signal in which the pitch component of speech of the speaker can be ordinarily contained, and may substantially cut off components not contained in this band. Also, in this case, the average pitch calculator 27 may determine whether or not the measured value of frequency notified by the pitch frequency measurement section 26 is distant by a certain amount or more from the range of value which can be assumed by the fundamental frequency of a speech of the speaker, and any measured value determined to be distant by a certain amount or more may be eliminated from the objects to be used for calculating the moving correction average.

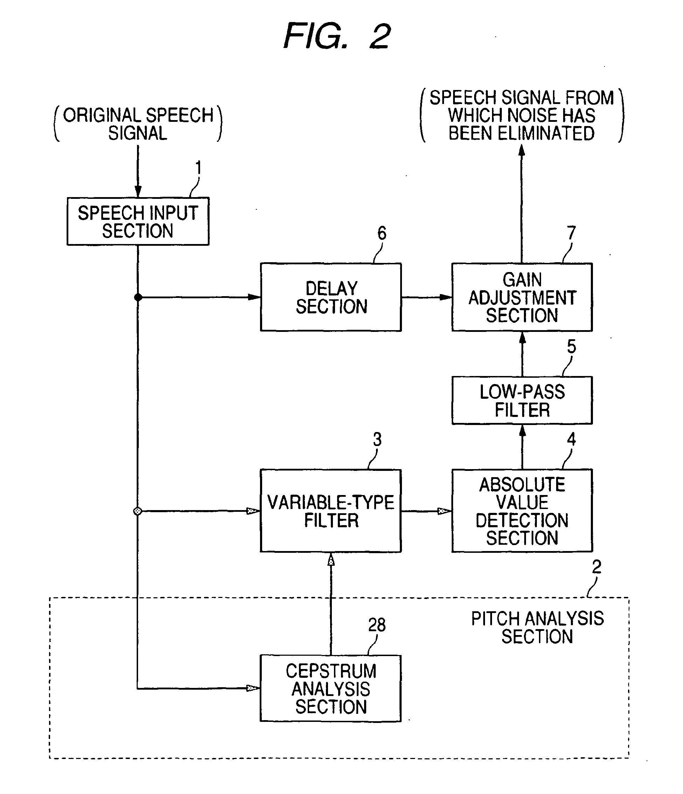

Also, instead of having the above described configuration, the pitch analysis section 2 may include a cepstrum analysis section 28 constituted of a processor, memory, etc., as shown in Figure 2.

The cepstrum analysis section 28 acquires an original speech signal from the speech input section 1, and converts the intensity of the original speech signal to a value substantially equal to a logarithm (base of the logarithm: arbitrary) of the original value, and determines the spectrum (i.e., cepstrum) of the value-converted speech signal by a fast Fourier transform technique (or any other technique for generating data representing a result obtained by Fourier transforming a discrete variable). Then a minimum value from among the frequencies which provide a maximum value of the cepstrum is identified as the fundamental frequency, and the identified fundamental frequency is notified to the variable-type filter 3.

Also, the pitch frequency measurement section 26 may determine a measured value of period of the pitch component of the original speech signal, notifying the value to the average pitch calculator 27. In this case, whenever a measured value of period is notified, the average pitch calculator 27 may determine the moving correction average of a number n of the latest determined periods to determine the frequency of the pitch component based on the value of moving correction average, notifying the determined frequency to the variable-type filter 3.

Also, the average pitch calculator 27 may calculate the time length of a time period not containing a large amount of the fundamental frequency component (i.e., a sequence of time periods in which the measured value of frequency notified by the pitch frequency measurement section 26 is distant by a certain amount or more from the range of value which can be assumed by the fundamental frequency of speech of an ordinary person) by use of a technique such as counting the number of the above described measurement pulse signals generated in this same time period, and notifying the measurement result to the delay section 6. In this case, when identifying a time length by which a time period following this time period and containing a large amount of the fundamental frequency component is to be delayed, the delay section 6 may handle this time length measured by the average pitch calculator 27 as the time length of the above described (2).

Also, each of the absolute value detection section 4 and gain adjustment section 7 does not always have to have the above described characteristic. Thus, for example, the signal generated by the absolute value detection section 4 may have a value obtained by assigning the absolute value of level of the pitch signal to a predetermined non-linear function. Also, the gain of the gain adjustment section 7 may be a non-linear function of the intensity of the pitch signal, or a non-linear function of the level of the gain adjustment signal. Also, the gain of the gain adjustment section 7 may have a characteristic such that the original speech signal is non-linear amplified or attenuated.

Human auditory sense has a non-linear property that recognizes a speech according to a level unproportional to the actual level of the speech, and more specifically, a property that recognizes a speech according to a level substantially proportional to a logarithm of the actual level of the speech.

Consequently, by determining the characteristics of the absolute value detection section 4 and gain adjustment section 7 in consideration of the properties of human auditory sense, the signal-to-noise-ratio etc. of a speech signal may be adjusted more satisfactorily to a desired standard, or the amplitude may be suppressed at the time of an extraordinary sound volume, while avoiding a state in which the speech represented by the speech signal outputted by the gain adjustment section 7 sounds unnatural relative to the original speech.

Also, the gain adjustment section 7 may amplify the original speech signal by use of a larger gain as the level of the gain adjustment signal supplied from the low pass filter 5 is lower (or may attenuate the original speech signal by use of a larger rate of attenuation as the level of the gain adjustment signal is higher).

Also, the speech data noise eliminator can be realized by use of an ordinary computer system. For example, the speech data noise eliminator executing the above described process can be constructed by installing on a personal computer having a function of acquiring a speech signal to process it according to a program, a program (hereinafter referred to as the noise elimination program) for executing the operations of the above described speech input section 1, pitch analysis section 2, variable-type filter 3, absolute value detection section 4, low-pass filter 5, delay section 6, and gain adjustment section 7, from a medium (magnetic tape, CD-ROM, etc.) storing the noise elimination program.

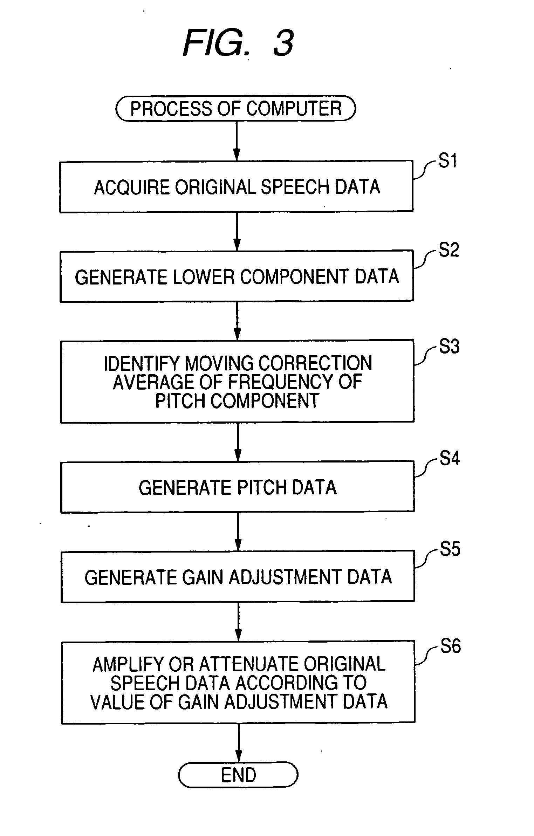

Specifically, the computer having the noise elimination program installed thereon executes, for example, a process shown in Figure 3 by running the noise elimination program.

More specifically, when the noise elimination program is initiated, firstly the computer acquires speech data representing the waveform of a speech uttered by a speaker (Figure 3, step S1). The acquisition of speech data may be performed by being supplied with the speech data from the outside. Alternatively, if the computer has a function of collecting a speech and converting it to speech data, the speech may be collected, whereby speech data representing the speech is generated.

Subsequently, the computer generates data obtained by substantially eliminating from the original speech data acquired in step S1, components not contained in a band in which the pitch component of a human speech can be ordinarily contained (step S2). Hereinafter, the data generated in step S2 is referred to as the lower component data.

Then the computer identifies sequentially from the beginning of the lower component data, the moving correction average of frequency of a number n (n: a predetermined positive integral number) of periods of the latest pitch components represented by the lower component data (step S3).

Specifically, in step S3, the computer analyzes the lower component data, and identifies sequentially from the beginning of the lower component data, a time period from when the intensity of components represented by the lower component data exceeds a predetermined reference level to when the above intensity exceeds again the reference level after becoming once the reference level or less (and/or a time period from when the intensity of the lower component data falls below a predetermined reference level to when the above intensity falls again below the reference level after becoming once the reference level or more), and identifies the inverse number of time length of the identified time period as the measured value of frequency of the pitch component within this same time period. Then the computer identifies as the moving correction average value of frequency, the arithmetic average of a number n of measured values of frequency in a number n of the latest identified time periods.

In step S3, it is determined whether or not the measured value is distant by a certain amount or more from the range of value which can be assumed by the fundamental frequency of speech of an ordinary person, and any measured value determined to be distant by a certain amount or more is eliminated from the objects to be used for calculating the moving correction average. When, for example, a number k (k: an integral number of one or more and smaller than n) of measured values are eliminated from among a number n of the latest identified measured values, the arithmetic average of a number (n - k) of the remaining measured values is calculated, for example; or alternatively, the arithmetic average is calculated by use of a number k of the latest measured values from among the (n + 1)-th values identified anew and not eliminated, instead of a number k of the eliminated measured values. When all of a number n (or a predetermined number of one or more and smaller than n) of the latest identified measured values is eliminated from the objects to be used for calculating the moving correction average, the computer does not calculate the moving correction average.

Meanwhile, the computer filters each interval of one period of the original speech data and thereby generates the pitch data (step S4). In step S4, it is desirable that the computer performs the filtering of one interval of the original speech data by adjusting a timing so that components other than the center frequency and vicinity thereof are substantially eliminated, the center frequency being obtained as the moving correction average which is determined in Step 3 by using the value of frequency in this said interval as the latest measured value. In step S4, when the moving correction average obtained by using the value of frequency of one interval of the original data as the latest measured value is not calculated, all the components of this same interval of the original speech data are cut off. It is desirable that the pass bandwidth of the filtering in step S4 is smaller than double the center frequency.

Subsequently, the computer generates data (hereinafter referred to as the gain adjustment data) representing a value obtained by filtering a value obtained by assigning the absolute value of the pitch data determined in Step 4 to a linear function (or a predetermined non-linear function) (step S5). The characteristic of the filtering performed in step S5 is such that the signal-to-noise ratio of an output speech data outputted in step 6 as described below can be higher than a desired value, for example. Thus, the characteristic is experimentally determined by performing experiments.

Subsequently, the computer amplifies (or attenuates) the original speech data by use of a gain proportional to the value of the gain adjustment data obtained in step S5 and outputs the resultant data (step S6). In step S6, a gain determined based on the intensity of the fundamental frequency component of one part of the original speech signal is applied from a time point which precedes a predetermined time period (specifically, for example, a maximum time length ordinarily taken up by a consonant immediately before a vowel) relative to the beginning of the one part, thereby amplifying or attenuating the original speech data.

The noise elimination program may be uploaded onto a Bulletin Board System (BBS) on the network to be distributed via a communications network. Also, a carrier wave may be modulated by a signal representing the noise elimination program, the modulated wave thus obtained being transmitted, an apparatus receiving this modulated wave demodulating it to reproduce the noise elimination program.

Also, the noise elimination program is initiated under the control of the OS similarly to other application programs and executed by the computer, thereby enabling execution of the above described process. When the OS bears part of the above described process, the part controlling this process may be eliminated from the noise elimination program.

### Industrial Applicability

As described above, with the present invention, a speech data noise elimination device, speech data noise elimination method, and program for surely eliminating a noise mixed in a speech can be realized.

## Claims

1. A speech signal noise elimination device comprising:
a pitch component extraction means which acquires a speech signal representing the waveform of a speech to extract the pitch component of the speech from the speech signal;
delay means having a predetermined delay time for delaying the speech signal; and
gain determination means which determines the gain of the speech signal based on the intensity of the extracted pitch component to amplify or attenuate the speech signal delayed via the delay means, by use of the determined gain,
wherein the pitch component extraction means comprises:
a variable filter which varies the pass band thereof according to a control and filters the speech signal to thereby extract components within the pass band; and
a filter characteristic determination section which, to cause the variable filter to extract the pitch component, identifies the fundamental frequency of the speech based on the speech signal and controls the variable filter so that the filter has a pass band in which components other than the identified fundamental frequency and vicinity thereof are cut off; **characterised in that**
the predetermined delay time of the delay means is equal to the sum of the possible maximum time length taken up by a consonant immediately before a vowel and at least a length of time delay between the input and output of the variable filter.

2. The speech signal noise elimination device according to claim 1, wherein the filter characteristic determination section includes a cepstrum analysis section which identifies as the fundamental frequency of the speech, a frequency at which the cepstrum of the speech signal has a maximal value.

3. The speech signal noise elimination device according to claim 1 or 2, wherein the filter characteristic determination section includes a cross detection section which filters a speech signal to eliminate a band in which the fundamental frequency component is not substantially contained, and identifies a timing at which non-eliminated components reach a predetermined value, and identifies the fundamental frequency based on the identified timing.

4. The speech signal noise elimination device according to claim 3, wherein:
the cross detection section determines, based on the identified timing, whether or not the speech contains the fundamental frequency component of a certain amount or more and, if not, the cross detection section notifies the variable filter that the pitch component is not contained; and
the variable filter cuts off the speech signal in response to the notification that the pitch component is not contained.

5. The speech signal noise elimination device according to any one of claims 1 to 4, wherein the gain determination means determines, based on the intensity of the extracted pitch component within one time period, the gain of the speech signal in the time period and a predetermined time period preceding the time period.

6. A speech signal noise elimination method comprising:
acquiring a speech signal representing the waveform of a speech to extract the pitch component of the speech from the speech signal; delaying the speech signal for a predetermined delay time ; and determining the gain of the speech signal based on the intensity of the extracted pitch component to amplify or attenuate the delayed speech signal by use of the determined gain,
whereby extracting the pitch component comprises:
filtering the speech signal with a variable filter which varies the pass band thereof according to a control to thereby extract components within the pass band; and
determinating a filter characteristic to cause the variable filter to extract the pitch component, by identifying the fundamental frequency of the speech based on the speech signal and controlling the variable filter so that the filter has a pass band in which components other than the identified fundamental frequency and vicinity thereof are cut off; **characterised in that**
the predetermined delay time of the delay means is equal to the sum of the possible maximum time length taken up by a consonant immediately before a vowel and at least a length of time delay between the input and output of the variable filter.

7. A program adapted to execute each of the steps of a method according to claim 6 when run on a computer.

## Patentansprüche

1. Sprachsignalgeräuschbeseitigungsvorrichtung, umfassend:
eine Tonhöhenkomponentenextraktionseinrichtung, die ein Sprachsignal, das die Wellenform einer Sprache darstellt, erfasst, um die Tonhöhenkomponente der Sprache aus dem Sprachsignal zu extrahieren;
eine Verzögerungseinrichtung mit einer vorgegebenen Verzögerungszeit zum Verzögern des Sprachsignals; und
eine Verstärkungsbestimmungseinrichtung, welche die Verstärkung des Sprachsignals basierend auf der Intensität der extrahierten Tonhöhenkomponente bestimmt, um das via die Verzögerungseinrichtung verzögerte Sprachsignal zu verstärken oder zu dämpfen, und zwar unter Verwendung der bestimmten Verstärkung,
wobei die Tonhöhenkomponentenextraktionseinrichtung umfasst:
ein variables Filter, das seinen Bandpass entsprechend einer Steuerung variiert und das Sprachsignal filtert, um **dadurch** Komponenten innerhalb des Bandpasses zu extrahieren; und
eine Filtercharakteristikbestimmungssektion, die, um das variable Filter zum Extrahieren der Tonhöhenkomponente zu veranlassen, die Grundfrequenz der Sprache basierend auf dem Sprachsignal identifiziert und das variable Filter so steuert, dass das Filter einen Bandpass aufweist, in dem Komponenten mit Ausnahme der identifizierten Grundfrequenz und deren naher Umgebung abgeschnitten sind;
**dadurch gekennzeichnet, dass**
die vorgegebene Verzögerungszeit der Verzögerungseinrichtung gleich der Summe ist aus der möglichen maximalen Zeitlänge, die von einem Konsonanten unmittelbar vor einem Vokal eingenommen wird, und zumindest einer Zeitverzögerungslänge zwischen dem Eingang und Ausgang des variablen Filters.

2. Sprachsignalgeräuschbeseitigungsvorrichtung nach Anspruch 1, wobei die Filtercharakteristikbestimmungssektion eine Cepstrum-Analysesektion einschließt, die als die Grundfrequenz der Sprache eine Frequenz identifiziert, bei der das Cepstrum des Sprachsignals einen Maximalwert aufweist.

3. Sprachsignalgeräuschbeseitigungsvorrichtung nach Anspruch 1 oder 2, wobei die Filtercharakteristikbestimmungssektion eine Durchgangsermittlungssektion einschließt, die ein Sprachsignal filtert, um ein Band zu beseitigen, in dem die Grundfrequenzkomponente nicht substanziell enthalten ist, und einen Zeitpunkt identifiziert, zu dem nicht beseitigte Komponenten einen vorgegebenen Wert erreichen, und die Grundfrequenz basierend auf dem identifizierten Zeitpunkt identifiziert.

4. Sprachsignalgeräuschbeseitigungsvorrichtung nach Anspruch 3, wobei:
die Durchgangsermittlungssektion, basierend auf dem identifizierten Zeitpunkt, bestimmt, ob die Sprache die Grundfrequenzkomponente in einer bestimmten Menge oder darüber enthält oder nicht, und, falls nicht, die Durchgangsermittlungssektion das variable Filter benachrichtigt, dass die Tonhöhenkomponente nicht enthalten ist; und
das variable Filter das Sprachsignal in Reaktion auf die Benachrichtigung abschneidet, dass die Tonhöhenkomponente nicht enthalten ist.

5. Sprachsignalgeräuschbeseitigungsvorrichtung nach einem der Ansprüche 1 bis 4, wobei die Verstärkungsbestimmungseinrichtung, basierend auf der Intensität der extrahierten Tonhöhenkomponente innerhalb eines Zeitraums, die Verstärkung des Sprachsignals in dem Zeitraum und einem vorgegebenen Zeitraum bestimmt, der dem Zeitraum vorausgeht.

6. Sprachsignalgeräuschbeseitigungsverfahren, umfassend:
Erfassen eines die Wellenform einer Sprache darstellenden Sprachsignals, um die Tonhöhenkomponente der Sprache aus dem Sprachsignal zu extrahieren;
Verzögern des Sprachsignals um eine vorgegebene Verzögerungszeit; und
Bestimmen der Verstärkung des Sprachsignals basierend auf der Intensität der extrahierten Tonhöhenkomponente, um das verzögerte Sprachsignal unter Verwendung der bestimmten Verstärkung zu verstärken oder zu dämpfen,
wobei das Extrahieren der Tonhöhenkomponente umfasst:
Filtern des Sprachsignals mit einem variablen Filter, das seinen Bandpass entsprechend einer Steuerung variiert, um **dadurch** Komponenten innerhalb des Bandpasses zu extrahieren; und
Bestimmen einer Filtercharakteristik, um das variable Filter zum Extrahieren der Tonhöhenkomponente zu veranlassen, durch Identifizieren der Grundfrequenz der Sprache basierend auf dem Sprachsignal und Steuern des variablen Filters in einer Weise, dass das Filter einen Bandpass aufweist, in dem Komponenten mit Ausnahme der identifizierten Grundfrequenz und deren naher Umgebung abgeschnitten sind;
**dadurch gekennzeichnet, dass**
die vorgegebene Verzögerungszeit der Verzögerungseinrichtung gleich der Summe ist aus der möglichen maximalen Zeitlänge, die von einem Konsonanten unmittelbar vor einem Vokal eingenommen wird, und zumindest einer Zeitverzögerungslänge zwischen dem Eingang und Ausgang des variablen Filters.

7. Programm, das so angepasst ist, dass es jeden der Schritte eines Verfahrens nach Anspruch 6 ausführt, wenn es auf einem Computer läuft.

## Revendications

1. Dispositif d'élimination de bruit d'un signal vocal comprenant:
un moyen d'extraction de composante de pas qui acquiert un signal vocal représentant la forme d'onde d'une parole pour extraire la composante de pas de la parole du signal vocal;
un moyen de retard ayant un temps de retard prédéterminé pour retarder le signal vocal; et
un moyen de détermination de gain qui détermine le gain du signal vocal sur la base de l'intensité de la composante de pas extraite pour amplifier ou atténuer le signal vocal, par l'intermédiaire du moyen de retard, par l'utilisation du gain déterminé, où le moyen d'extraction de composante de pas comprend:
un filtre variable qui fait varier la bande passante de celui-ci en accord avec une commande et qui filtre le signal vocal pour extraire ainsi des composantes dans la bande passante; et
une section de détermination de caractéristiques de filtre qui, pour amener le filtre variable à extraire la composante de pas, identifie la fréquence fondamentale de la parole sur la base du signal vocal et commande le filtre variable de façon que le filtre possède une bande passante dans laquelle des composantes autres que la fréquence fondamentale identifiée et son voisinage sont coupés;
**caractérisé en ce que**
le temps de retard prédéterminé du moyen de retard est égal à la somme de la longueur de temps maximal possible utilisé par une consonne directement avant une voyelle et au moins une longueur de retard de temps entre l'entrée et la sortie du filtre variable.

2. Dispositif d'élimination de bruit d'un signal vocal selon la revendication 1, où la section de détermination de caractéristiques de filtre comprend une section d'analyse de cepstre qui identifie, comme fréquence fondamentale de la parole, une fréquence à laquelle le cepstre du signal vocal présente une valeur maximale.

3. Dispositif d'élimination de bruit d'un signal vocal selon la revendication 1 ou 2, où la section de détermination de caractéristiques de filtre comprend une section de détection croisée qui filtre un signal vocal afin d'éliminer une bande dans laquelle la composante de fréquence fondamentale n'est pas sensiblement contenue, et identifie un instant auquel des composantes non éliminées atteignent une valeur prédéterminée, et identifie la fréquence fondamentale sur la base de l'instant identifié.

4. Dispositif d'élimination de bruit d'un signal vocal selon la revendication 3, dans lequel:
la section de détection croisée détermine, sur la base de l'instant identifié, si oui ou non la parole contient la composante de fréquence fondamentale d'une certaine quantité ou plus et, si c'est non, la section de détection croisée notifie au filtre variable que la composante de pas n'est pas comprise; et
le filtre variable coupe le signal vocal en réponse à la notification que la composante de pas n'est pas comprise.

5. Dispositif d'élimination de bruit d'un signal vocal selon l'une des revendications 1 à 4, où le moyen de détermination de gain détermine, sur la base de l'intensité de la composante de pas extraite dans une période de temps, le gain du signal vocal dans la période de temps ainsi qu'une période de temps prédéterminée précédant la période de temps.

6. Procédé d'élimination de bruit d'un signal vocal comprenant:
l'acquisition d'un signal vocal représentant la forme d'onde d'une parole pour extraire la composante de pas de la parole du signal vocal;
retarder le signal vocal pendant un temps de retard prédéterminé; et
déterminer le gain du signal vocal sur la base de l'intensité de la composante de pas extraite pour amplifier ou atténuer le signal vocal retardé en utilisant le gain déterminé,
où l'extraction de la composante de pas comprend:
le filtrage du signal vocal par un filtre variable qui fait varier la bande passante de celui-ci en accord avec une commande filtrant le signal vocal pour extraire ainsi des composantes dans la bande passante; et
la détermination d'une caractéristique de filtre pour amener le filtre variable à extraire la composante de pas en identifiant la fréquence fondamentale de la parole sur la base du signal vocal et la commande du filtre variable de sorte que le filtre possède une bande passante dans laquelle les composantes autres que la fréquence fondamentale identifiée et son voisinage sont coupés;
**caractérisé en ce que**
le temps de retard prédéterminé du moyen de retard est égal à la somme de la longueur de temps maximal possible utilisé par une consonnante directement avant une voyelle, et au moins une longueur de retard de temps entre l'entrée et la sortie du filtre variable.

7. Programme conçu pour exécuter chacune des étapes d'un procédé selon la revendication 6, lorsqu'il est exécuté sur un ordinateur.
